# FASCICULE DE BREVET EUROPEEN

(11) **EP 3 632 012 B1**
(45) Date de publication et mention de la délivrance du brevet: **23.02.2022**
(21) Numéro de dépôt: 18724278.9
(22) Date de dépôt: 22.05.2018
(51) Int. Cl.: H04B 17/29, H04B 17/309, H01Q 3/46, H01Q 15/14

(54) **SYSTÈME COMPRENANT UN DISPOSITIF DE MISE EN FORME D'ONDE ET RÉCEPTEUR D'ONDE**
SYSTEM BESTEHEND AUS EINER WELLENFORMGEBUNGSVORRICHTUNG UND EINEM WELLENEMPFÄNGER
SYSTEM COMPRISING A WAVEFORM SHAPING DEVICE AND A WAVE RECEIVER

(30) Priorité: 22.05.2017 FR 1754513
(43) Date de publication de la demande: 08.04.2020
(73) Titulaire: Greenerwave, 06200 Nice (FR); Centre National de la Recherche Scientifique - CNRS, 75016 Paris (FR); Ecole Supérieure de Physique et de Chimie Industrielles de la Ville de Paris, 75005 Paris (FR)
(72) Inventeur: LEROSEY, Geoffroy, 75010 Paris (FR); FINK, Mathias, 92190 Meudon (FR); DEL HOUGNE, Philipp, 75014 Paris (FR); FLOUME, Timmy, 75020 Paris (FR)
(74) Mandataire: Plasseraud IP
(86) Numéro de dépôt international: PCT/EP2018/063311
(87) Numéro de publication internationale: WO 2018/215415

(56) Documents cités:
- FR-A1- 3 010 836
- US-A1- 2004 263 408

## Description

### DOMAINE TECHNIQUE

La présente invention est relative à un système comprenant un dispositif de mise en forme d'onde.

### ETAT DE LA TECHNIQUE ANTERIEURE

Plus particulièrement, l'invention concerne un système comprenant un dispositif de mise en forme d'onde pour optimiser la réception d'une onde primaire sur un récepteur, ledit dispositif de mise en forme d'onde comprenant :
- une surface qui interagit avec l'onde primaire, ladite surface comprenant une pluralité d'éléments réglables pour modifier une impédance de ladite surface et pour modifier la manière dont l'onde primaire est réfléchie et/ou transmise par ladite surface, et
- un contrôleur relié à la surface, ledit contrôleur comprenant un module d'optimisation qui maximise ou minimise une valeur pour déterminer des paramètres, et ledit contrôleur contrôle les éléments réglables à partir desdits paramètres.

Le document WO 2015/039769 montre l'utilisation d'un dispositif de mise en forme d'onde de ce type qui récupère par un dispositif de transmission, une onde pilote émise par un dispositif électronique mobile (récepteur). Le dispositif électronique mobile est par exemple un téléphone mobile ou un ordinateur portable. Cette onde pilote comprend par exemple le niveau ou la qualité de réception d'une onde incidente sur le dispositif électronique mobile.

Ce dispositif de mise en forme est donc en liaison sans fil avec le dispositif électronique mobile, ce qui est parfois peu pratique ou très contraignant notamment pour ce dispositif électronique mobile qui doit gérer deux communications sans fil : la communication sans fil avec le réseau et la communication sans fil et avec le dispositif de mise en forme.

En outre, le dispositif de mise en forme d'onde reçoit l'information contenue dans l'onde pilote avec une périodicité pilotée par le dispositif électronique mobile. Cette périodicité est parfois insuffisante pour une adaptation suffisamment rapide de la surface électromagnétique.

Le document US 2004/263408 montre un procédé et dispositif pour commander la direction d'un faisceau. Une antenne conique illumine une surface à impédance pilotable, ladite surface comprenant des résonateurs qui sont modifiés de manière séquentielle pour améliorer la transmission d'information.

Le document FR 3 010 836 est le document de priorité du document WO 2015/039769.

### EXPOSE DE L'INVENTION

La présente invention a pour but de proposer une amélioration au dispositif de mise en forme d'onde, dans laquelle ce dispositif de mise en forme d'onde n'a pas besoin de cette liaison sans fil avec le dispositif électronique mobile (le récepteur de l'onde primaire).
1. A cet effet, le système comprend un émetteur adapté pour émettre une onde primaire, un récepteur adapté pour recevoir l'onde primaire et, et un dispositif de mise en forme d'onde adapté pour améliorer au niveau du récepteur la réception de l'onde primaire, dans lequel :
   - le récepteur comprend :
      - une antenne adaptée pour recevoir l'onde primaire provenant de l'émetteur, et
      - une unité de traitement reliée à ladite antenne pour traiter les signaux provenant de l'antenne, et
      - un élément de signature adapté pour émettre une onde secondaire qui est fonction de l'onde primaire reçue par l'antenne,
      - l'élément de signature étant un circuit électrique non linéaire qui déforme le signal de l'onde primaire avec une signature prédéterminée pour générer le signal de l'onde secondaire,
   - le dispositif de mise en forme d'onde comprend une surface et un contrôleur du type précité, et
      - un dispositif de réception d'onde qui est connecté au contrôleur et qui mesure une onde secondaire générée par la réception de l'onde primaire par un récepteur, sans que le récepteur ne transmette au dispositif de mise en forme d'onde une information concernant sa réception de l'onde primaire, et
      - le contrôleur comprenant un module d'estimation qui détermine une valeur estimée de la réception de l'onde primaire par le récepteur grâce à la mesure de l'onde secondaire, et le module d'optimisation du contrôleur utilise ladite valeur estimée pour déterminer les paramètres de contrôle des éléments réglables.

Grâce à ces dispositions, le dispositif de mise en forme d'onde déduit une valeur (intensité, niveau, qualité...) concernant la réception par le récepteur par la mesure d'un signal généré implicitement par l'antenne de réception de ce récepteur lors la réception de l'onde primaire par ce récepteur.

Le dispositif de mise en forme n'a ainsi pas besoin d'être en connexion avec le récepteur puisqu'il déduit cette valeur sans qu'un signal pilote de rétroaction ne la contienne explicitement. L'onde secondaire constitue ainsi un signal de rétroaction virtuel sans collaboration avec le récepteur : i.e. sans intervention volontaire du récepteur.

Le dispositif de mise en forme est alors plus rapide dans son fonctionnement, c'est-à-dire pour trouver des paramètres qui améliorent la réception de l'onde primaire par le récepteur.

Le dispositif de mise en forme est alors plus performant, c'est-à-dire que les paramètres optimaux conduisent à une meilleure amélioration de la réception de l'onde primaire par le récepteur.

Enfin, le récepteur consomme moins d'énergie interne et en reçoit plus par l'onde primaire, ce qui est très avantageux pour un dispositif autonome.

Dans divers modes de réalisation du système selon l'invention, on peut éventuellement avoir recours en outre à l'une et/ou à l'autre des dispositions suivantes.

Selon un aspect, le dispositif de mise en forme d'onde comprend en outre un dispositif de transmission relié au contrôleur et relié au à l'émetteur de l'onde primaire par une liaison de réseau pour connaitre un instant temporel auquel l'émetteur émet l'onde primaire, et le module d'estimation utilise ledit instant temporel pour déterminer la valeur estimée concernant ledit récepteur.

Selon un aspect, le module d'estimation effectue une reconnaissance du récepteur par la comparaison d'un traitement de la mesure de l'onde secondaire à une signature prédéterminée correspondant audit récepteur, puis en déduit la valeur estimée.

Selon un aspect, la comparaison est un calcul de corrélation ou d'inter-corrélation entre le traitement de la mesure de l'onde secondaire et signature prédéterminée.

Selon un aspect, le traitement comprend une extraction d'un signal temporel, par exemple par filtrage.

Selon un aspect, l'onde primaire a une fréquence principale, et le traitement comprend une extraction d'au moins une fréquence de signature différente de ladite fréquence principale.

Selon un aspect, la fréquence de signature est une harmonique entière supérieure ou inférieure de la fréquence principale.

Selon un aspect, le traitement comprend une détection hétérodyne qui abaisse les fréquences de la mesure de l'onde secondaire.

Selon un aspect, le traitement comprend un décodage d'un code numérique inclut dans la mesure de l'onde secondaire.

Selon un aspect, le dispositif de réception d'onde comprend une antenne multiple pour spatialement sélectionner une région incluant le récepteur.

Selon un aspect, le dispositif de réception d'onde effectue une focalisation sur le récepteur par formation de voie.

Selon un aspect, le dispositif de mise en forme d'onde est tel que :
- le récepteur est un module de récupération d'énergie de l'onde primaire, et
- la valeur estimée correspond à une estimation de l'intensité de l'onde primaire reçue par le récepteur.

Selon un aspect, le dispositif de mise en forme d'onde est tel que :
- le récepteur est un dispositif de communication sans fil,
- l'émetteur est un point d'accès d'un réseau de communication sans fil, qui émet une onde primaire correspondant à une communication avec le dispositif de communication sans fil.

Selon un aspect, le module d'estimation espionne la communication par une mesure de l'onde primaire et en extrait des données pour déterminer la valeur estimée.

Selon un aspect, la mesure de l'onde primaire pour espionner la communication est effectuée par le dispositif de réception d'onde qui mesure l'onde secondaire.

Selon un aspect, l'instant temporel est l'instant auquel le point d'accès établit ladite communication avec le dispositif de communication sans fil.

Selon un aspect, le module d'estimation reçoit du point d'accès et par la liaison de réseau connectée au dispositif de transmission, la communication entre ledit point d'accès et le récepteur, et en extrait des données pour déterminer la valeur estimée.

Selon un aspect, la surface est intégrée dans un élément choisi dans une liste comprenant :
- des éléments de construction de bâtiment, tels que un parpaing, une brique, un isolant, une plaque isolante, une plaque de plâtre, et
- des éléments d'habillage de bâtiment, tels que un sol en parquet, un sol en moquette, un sol en carrelage, un panneau d'habillage, une cloison rapportée, un plafond, une plaque de faux plafond, et
- des éléments de mobilier, tels que un bureau, une armoire, un meuble à étagère, une étagère, un miroir, un tableau décoratif, un luminaire.

Selon un aspect, l'élément de signature est relié l'antenne pour lui faire émettre l'onde secondaire.

Selon un aspect, l'élément de signature est un élément passif.

Selon un aspect, l'onde primaire a une fréquence principale, et dans lequel la signature prédéterminée est au moins une fréquence de signature différente de ladite fréquence principale.

Selon un aspect, la fréquence de signature est une harmonique entière supérieure ou inférieure de la fréquence principale.

### BREVE DESCRIPTION DES DESSINS

D'autres caractéristiques et avantages de l'invention apparaîtront au cours de la description suivante d'un de ses modes de réalisation, donné à titre d'exemple non limitatif, en regard des dessins joints.

Sur les dessins :
- la figure 1 est une vue schématique générale d'un premier mode de réalisation de dispositif de mise en forme d'onde selon l'invention ;
- la figure 2 est une vue détaillée du dispositif de mise en forme d'onde de la figure 1 ;
- la figure 3 est une vue schématique générale d'un deuxième mode de réalisation de dispositif de mise en forme d'onde selon l'invention ;
- la figure 4 est une vue détaillée du dispositif de mise en forme d'onde de la figure 3 ; et
- la figure 5 est une courbe exemple d'amélioration de la réception d'un module de récupération d'énergie grâce à un dispositif de mise en forme d'onde selon l'invention ; et
- la figure 6 est une courbe montrant les itérations de l'optimisation du dispositif de mise en forme utilisé pour la figure 5.

Sur les différentes figures, les mêmes références numériques désignent des éléments identiques ou similaires.

### DESCRIPTION DETAILLEE DE MODES DE REALISATION

L'invention concerne un système comprenant un dispositif de mise en forme d'onde. L'onde est une onde principale ou onde primaire qui peut être de nature électromagnétique, acoustique ou vibratoire.

Par souci de simplicité, l'invention sera décrite principalement dans le cadre de l'application d'une onde électromagnétique, notamment pour une utilisation de transmissions sans fil de divers types :
- transmission d'énergie électromagnétique, ou
- téléphonie mobile de type GSM, 3G, 4G, 5G, ou
- réseau sans fil de type WiFi, Bluetooth, ou
- réseau entre des objets connectés,
   par exemple de type iOT, ou
- lecteurs de badges de type RFID, ou
- toute autre application entre dispositifs ayant une connexion sans fil par onde radio.

Mais, l'invention s'applique à tout domaine fréquentiel des ondes.

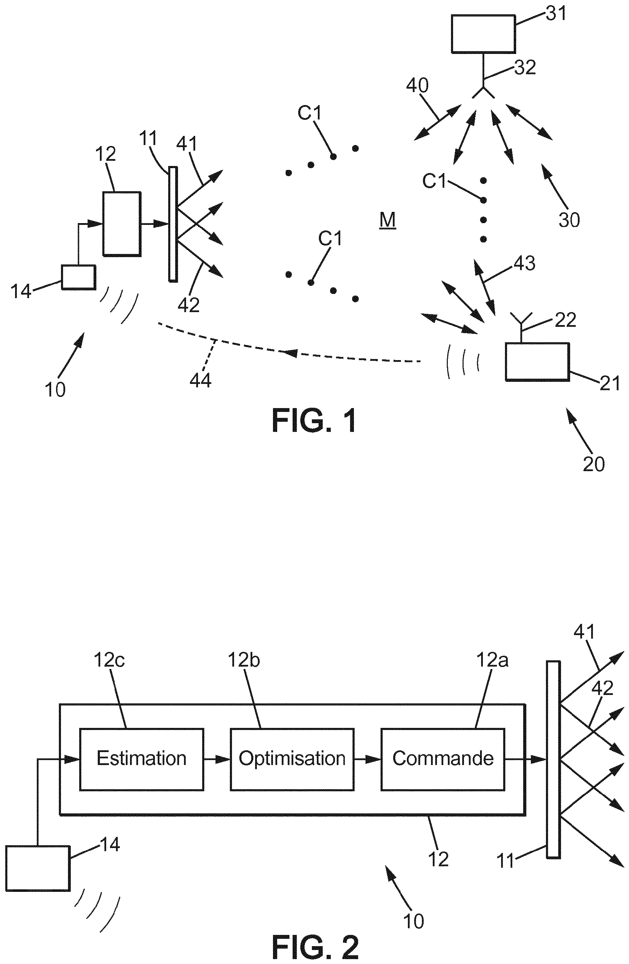

La **figure 1** montre une vue schématique montrant une utilisation générale d'un dispositif de mise en forme d'onde 10 selon un premier mode de réalisation de l'invention, qui améliore la réception d'une onde primaire par un récepteur 20.

L'ensemble du système comprend :
- un premier dispositif appelé émetteur 30 adapté pour au moins émettre une onde primaire 40 dans un milieu M de propagation des ondes, et éventuellement réciproquement recevoir une onde primaire dans ce milieu,
- un deuxième dispositif appelé récepteur 20 adapté pour au moins recevoir une onde primaire transmise 43 dans ce milieu, ladite onde primaire transmise pouvant être transmise directement ou par des réflexions et/ou transmissions, et/ou une combinaison multiples desdites transmissions et/ou réflexions, et
- un dispositif de mise en forme d'onde 10 adapté pour améliorer au niveau du récepteur 20, la réception de l'onde primaire 40 émise par l'émetteur 30 et reçue comme une onde primaire transmise 43.

**L'émetteur 30** est un dispositif d'émission sans fil, qui comprend :
- une antenne de réseau 32 qui émet l'onde primaire 40 qui se propage dans le milieu M, ladite antenne de réseau 32 pouvant éventuellement réciproquement recevoir une onde primaire 40 et
- une unité de communication 31 qui pilote ladite antenne de réseau 32.

**Le récepteur 20** est un dispositif de réception sans fil, qui comprend :
- une antenne 22 (ou dispositif de réception) qui reçoit une onde primaire transmise 43 qui s'est propagée dans le milieu M, ladite antenne 22 pouvant éventuellement réciproquement émettre une onde dans le milieu, et
- une unité de traitement 21 reliée à ladite antenne 22 pour traiter les signaux provenant de l'antenne 22 et destinés à l'antenne 22.

Le récepteur 20 est éventuellement un dispositif mobile ou apte à être déplacé entre un endroit vers un autre. Il est alimenté par une prise électrique ou par une batterie interne. Le récepteur 20 peut ne pas être mobile, et sa position peut être déterminée par diverses raisons pouvant prendre en compte la qualité de réception des ondes primaires provenant de l'émetteur 30.

Le récepteur 20 reçoit donc l'onde primaire en provenance de l'antenne de réseau 32 de l'émetteur 30 de manière directe et/ou indirecte par réflexion sur des éléments du milieu (l'environnement), sous la forme d'une onde primaire transmise 43 qui est la combinaison des contributions de toutes ces trajets directs ou indirects.

**Le dispositif** de **mise** en **forme d'onde 10** comprend :
- une surface adaptable (électromagnétique) 11 qui réfléchit une onde radio primaire incidente 41 en une onde réfléchie 42, lesdites ondes se propageant dans le même milieu, et
- un contrôleur 12 relié à la surface adaptable (électromagnétique) 11 pour contrôler ladite surface adaptable 11, notamment pour en faire varier une impédance (électromagnétique), ce qui modifie la manière dont l'onde incidente 41 est réfléchie en onde réfléchie 42.

Le dispositif de mise en forme d'onde 10 est avantageusement situé dans un milieu présentant des difficultés de réception pour un ou des récepteurs 20 sans fil. Le dispositif de mise en forme d'onde a ainsi pour but d'améliorer la réception du récepteur 20 dans une zone englobant ce récepteur 20 et le dispositif de mise en forme d'onde 10. Ce dispositif de mise en forme d'onde 10 est par exemple utile dans un environnement présentant des réflexions nombreuses et/ou complexes pour les ondes, lesdites réflexions perturbant la réception du récepteur 20. Le dispositif de mise en forme d'onde 10 génère une autre réflexion qui est contrôlée pour améliorer la réception du récepteur 20.

Le dispositif de mise en forme d'onde 10 est ainsi à portée du récepteur 20 et à portée de l'émetteur 30, i.e. à une distance pour permettre la réception d'une onde incidente 41 non nulle, et à une distance du récepteur 20 pour permettre la réception d'une contribution d'onde transmise 43 non nulle. Ceci dépend des distances, mais également du milieu de propagation comme précédemment expliqué (réflexions multiples).

Le dispositif de mise en forme d'onde 10 réfléchit l'onde incidente 41 émise par l'émetteur 30 ou réfléchie par un autre dispositif de mise en forme d'onde, en une onde réfléchie 42. D'une manière très simplifiée, l'onde réfléchie 42 se propage alors également dans le milieu, par exemple vers le récepteur 20 où elle contribue à l'onde radio primaire transmise 43 reçue par ledit récepteur 20.

La surface adaptable (électromagnétique) 11 peut être construite de nombreuses façons.

Le document de brevet n° US 6 538 621 montre un exemple de surface électromagnétique dont l'impédance est adaptable ou modifiable. Cette surface électromagnétique 11 comprend une pluralité d'éléments résonateurs, chaque élément résonateur étant réglable. La surface électromagnétiques 11 de ce document comprend des éléments plaques situés à distance d'un plan de masse, les éléments plaques voisins étant connectés entres eux par une capacité variable, chaque capacité variable pouvant être pilotée par un potentiel de commande. L'impédance de la surface électromagnétique est ainsi modifiée, par exemple pour focaliser l'onde réfléchie 42 ou pour donner une direction spatiale à l'onde réfléchie 42. Eventuellement, la surface électromagnétique 11 est constituée d'une pluralité de cellules, chaque cellule comprenant deux éléments résonateurs différents.

Le document de brevet n° WO 2015/039769 cite et montre d'autres types d'éléments résonateurs pouvant être utilisés dans une surface électromagnétique à impédance adaptable :
- Une diode variable peut remplacer la capacité variable,
- les éléments résonateurs peuvent être d'un seul type de polarisation ou de deux types de polarisation, éventuellement répartis de manière alternée sur la surface,
- les éléments résonateurs ont une ou plusieurs fréquences de résonnance pour contrôler une bande de fréquence prédéterminée,
- les éléments résonateurs sont des éléments binaires à deux états, par exemple définis par un changement de phase ou d'amplitude de l'onde modifiée.

De nombreuses variantes d'éléments résonateurs connus peuvent être utilisées pour former une surface électromagnétique 11 à impédance adaptable.

Le contrôleur 12 du dispositif de mise en forme d'onde 10 pilote par exemple tous les éléments réglables (par exemple, capacité ou diode variables) de la surface électromagnétique 11 ce qui permet de modifier son impédance. Cette modification est bien plus complexe qu'une focalisation ou une directivité spatiale. Elle modifie la répartition spatiale de l'onde radio du premier canal de communication Cl dans une zone autour du dispositif de mise en forme d'onde 10 jusqu'au récepteur 20.

Dans la demande de brevet WO 2015/039769 le dispositif de mise en forme 10 comprend un dispositif de transmission pour se connecter au récepteur 20 (dispositif électronique mobile), et récupérer des informations contenues dans une onde pilote provenant de ce dispositif de transmission de ce récepteur 20, ces informations pouvant être le niveau ou la qualité de la communication entre l'émetteur (la station de réseau ou point d'accès) et le récepteur (dispositif électronique mobile).

Les inventeurs ont constaté qu'ils pouvaient se passer d'une telle connexion entre récepteur 20 et le dispositif de mise en forme d'onde 10 : la simple réception par l'antenne 22 de l'onde radio transmise 43 modifiée (provenant d'une onde réfléchie 42) émet elle-même et immédiatement une onde secondaire 44 qui est une réflexion de l'onde radio transmise 43. Cette onde secondaire 44 a des caractéristiques physiques qui sont fonctions de la réception de l'onde radio transmise 43 reçue par l'antenne 22 du récepteur 20, c'est-à-dire de la réception radio entre l'antenne de réseau 32 et l'antenne 22 du récepteur 20.

Lesdites caractéristiques physiques sont une sorte de signature de cette réception, et il est possible d'estimer des grandeurs qui sont par exemple :
- une estimation du niveau (amplitude, puissance, intensité) de réception de l'onde radio transmise 43 reçue par le récepteur 20 à travers le milieu entre l'émetteur 30 et le récepteur 20, avec la contribution de l'onde réfléchie 42 provenant du dispositif de mise en forme d'onde 10, ou
- une estimation de la qualité (taux d'interférence, bande passante, débit) de la réception de l'onde radio transmise 43 reçue par le récepteur 20.

**Le dispositif de mise en forme d'onde 10 selon l'invention** est alors amélioré car:
- il comprend en outre un dispositif de réception d'onde 14 qui est connecté au contrôleur 12, et qui est adapté à mesurer l'onde secondaire 44 produite par la réception de l'onde primaire transmise entre l'émetteur 30 et le récepteur 20, et
- le contrôleur 12 comprend un module d'estimation 12c qui détermine une valeur estimée de la réception de l'onde primaire par le récepteur grâce à la mesure de l'onde secondaire, et le module d'optimisation 12b du contrôleur utilise ladite valeur estimée pour déterminer les paramètres de contrôle des éléments réglables.

Le récepteur 20 n'a aucune connexion avec le dispositif de mise en forme d'onde 10, et inversement. Le récepteur 20 ne transmet pas au dispositif de mise en forme d'onde 10 une information concernant la réception de l'onde radio transmise 43, i.e. la réception de l'onde provenant de l'émetteur 30.

Le contrôleur 12 détermine alors indirectement une valeur estimée de cette réception (onde radio transmise 43) uniquement à l'aide de la mesure de l'onde secondaire 44, par exemple au moyen d'un module d'estimation 12c comme représenté en **figure 2****.**

L'onde secondaire 44 permet ainsi de réaliser une sorte de boucle de rétroaction sans l'intervention du récepteur 20, i.e. sans sa collaboration dans le fonctionnement de cette boucle de rétroaction. Les inventeurs ont constaté que cette mesure de l'onde secondaire 44 est un signal suffisant pour que le contrôleur 12 effectue les étapes suivantes : optimisation et détermination de paramètres, puis commande de la surface adaptable (électromagnétique) 11 avec ces paramètres.

Ainsi, le contrôleur 12 comprend :
- un module d'estimation 12c qui utilise la mesure de l'onde secondaire 44 pour estimer ou calculer une valeur estimée correspondant à la réception par le récepteur 20 (estimation du niveau ou estimation de qualité),
- un module d'optimisation 12b qui reçoit la valeur estimée par le module d'estimation 12c et qui détermine des paramètres de commande de la surface adaptable (électromagnétique) 11, et
- un module de commande 12a relié à la surface adaptable (électromagnétique) 11, ledit module de commande 12a appliquant les paramètres de commande à la surface adaptable (électromagnétique) 11 pour modifier son impédance.

Le module d'estimation 12c peut être implémenté de diverses manières.

Par exemple, le module d'estimation 12c effectue un filtrage fréquentiel pour déterminer la valeur estimée. L'antenne 22 du récepteur 20 a éventuellement un élément non linéaire qui transforme l'onde radio transmise 43 et qui émet une onde secondaire 44 qui comprend des composantes fréquentielle prédéterminées, par exemple de fréquences harmoniques d'une fréquence de base de l'onde primaire 40. Le module d'estimation 12c filtre ces composantes fréquentielles pour en extraire des caractéristiques (amplitude, phase) d'une ou plusieurs de ces fréquences harmoniques et pour en déduire la valeur estimée.

Optionnellement, le module d'estimation 12c met en œuvre également un procédé de reconnaissance qui permet d'identifier que la mesure de l'onde secondaire 44 correspond bien à une transmission entre l'émetteur 30 et le récepteur 20.

Le procédé de reconnaissance effectue par exemple une comparaison d'un traitement de la mesure de l'onde secondaire à une signature prédéterminée correspondant au récepteur 20 (caractéristique physique du récepteur 20), ladite signature prédéterminée étant par exemple préenregistrée dans une mémoire.

Le traitement comprend par exemple une extraction d'un signal temporel de la mesure de l'onde secondaire.

Le traitement comprend par exemple une extraction d'une ou plusieurs fréquences de signature de la mesure de l'onde secondaire.

L'onde primaire a par exemple une fréquence principale f₀ (typiquement une fréquence d'onde porteuse d'une onde de transmission), et la fréquence de signature est une fréquence différente de ladite fréquence de principale, afin de caractériser et reconnaitre l'onde secondaire du récepteur 20.

Avantageusement, la fréquence signature est une harmonique entière supérieure (par exemple 2.f₀ ou 3.f₀) de la fréquence principale f₀, ou une harmonique entière inférieure (par exemple f₀/2 ou f₀/3) de la fréquence principale f₀.

Le traitement comprend par exemple un détecteur hétérodyne qui permet d'abaisser les fréquences des signaux.

Le traitement comprend éventuellement une démodulation de fréquence.

Le traitement comprend par exemple un décodage d'un code numérique inclut dans la mesure de l'onde secondaire.

Le traitement comprend ainsi éventuellement un ou plusieurs processus parmi un filtrage fréquentiel, un décodage temporel, détection d'enveloppe, calcul de moyenne, calcul de maximum, et leurs équivalents.

Le traitement et la comparaison à la signature prédéterminée permet de déduire la valeur estimée représentative de l'intensité de l'onde transmise 43 reçue par le récepteur 20, et alors d'effectuer l'optimisation décrite ci-après.

La signature prédéterminée est une caractéristique physique intrinsèque de l'antenne 22 du récepteur 20 ou une caractéristique physique ajoutée à l'antenne 22 ou reliée à l'antenne 22 pour reconnaitre le récepteur 20, par exemple parmi une pluralité de récepteur.

La comparaison peut être implémentée de diverses façons incluant un calcul de corrélation ou un calcul d'inter corrélation, soit directement de la mesure de l'onde secondaire, soit indirectement après avoir effectué un traitement tel que cité ci-dessus, ou une simple comparaison numérique dans le cas du décodage d'un code numérique.

Cette signature prédéterminée est par exemple non linéarité générée par l'élément non linéaire qui transforme l'onde radio transmise 43 et qui émet une onde secondaire 44.

Cette signature prédéterminée est par exemple une ou plusieurs fréquences de résonances de résonnances excitées de l'antenne 22 ou d'un élément ajouté.

Le module d'optimisation 12b exécute un algorithme d'optimisation sur la base du jeu de paramètres précédents (temporellement), des valeurs estimées précédentes et de la valeur estimée actuelle déterminée par le module d'estimation 12c.

L'algorithme d'optimisation peut être une maximisation de la valeur estimée ou une minimisation de la valeur estimée, selon la grandeur représentée par ladite valeur. En plusieurs étapes successives, l'algorithme d'optimisation permet d'obtenir un jeu de paramètres optimal.

Ce jeu de paramètre optimal est différent de celui qui serait obtenu si le récepteur 20 transmettait une information sur la réception (niveau, qualité). Il donne une optimisation moins performante mais suffisante pour obtenir une réelle amélioration de la réception.

Par contre, l'optimisation peut être réalisée plus rapidement, parce que le récepteur 20 n'a pas besoin de transmettre ces informations par une quelconque connexion, et parce que l'onde secondaire 44 est directement et physiquement liée à l'onde radio transmise 43 reçue par le récepteur 20 : Le dispositif de mise en forme d'onde 10 peut alors estimer la valeur estimée avec une périodicité supérieure de celle que réaliserait un récepteur 20 qui alloue peu de ressource à cette fonction, fonction qui n'est qu'une fonction d'information à faible périodicité ou fréquence de rafraîchissement, alors que le dispositif de mise en forme d'onde 10 l'utilise dans un processus d'optimisation qui doit être précis et rapide.

De plus, comme le récepteur 20 ne transmet pas d'information par une connexion, il consomme moins d'énergie, ce qui est important car le récepteur 20 est le plus souvent du dispositif mobile alimenté par une batterie, ou un dispositif alimenté par une récupération de l'énergie de l'onde primaire. Cet avantage énergétique est amplifié par l'optimisation du dispositif de mise en forme d'onde 10 qui augmente le niveau de réception sur le récepteur 20 (i.e. le niveau d'énergie).

Le module de commande 12a du contrôleur 12 applique alors le jeu de paramètres déterminés par le module d'optimisation 12b et commande les éléments résonateurs réglables de la surface adaptable (électromagnétique) 11. Ce processus détermine un état particulier de la surface adaptable (électromagnétique) 11 qui modifie l'onde radio incidente 41 en onde radio réfléchie 42.

L'onde radio transmise 43 reçue par le récepteur 20 est une combinaison de cette onde réfléchie 42 et de l'onde radio primaire 40 provenant de l'antenne de réseau 32.

De nombreux algorithmes d'optimisation connus peuvent être utilisés.

Le dispositif de réception 14 comprend par exemple une unique antenne de réception.

Selon une variante, le dispositif de réception 14 comprend une pluralité d'antennes (au moins deux) et une unité de traitement qui combine les signaux de ces antennes, par exemple pour spatialement sélectionner une région spatiale, par exemple située autour du récepteur 20.

L'unité de traitement du dispositif de réception 14 effectue éventuellement une formation de voie et focaliser la réception de l'onde secondaire 44 dans une zone spatiale prédéterminée autour du récepteur 20.

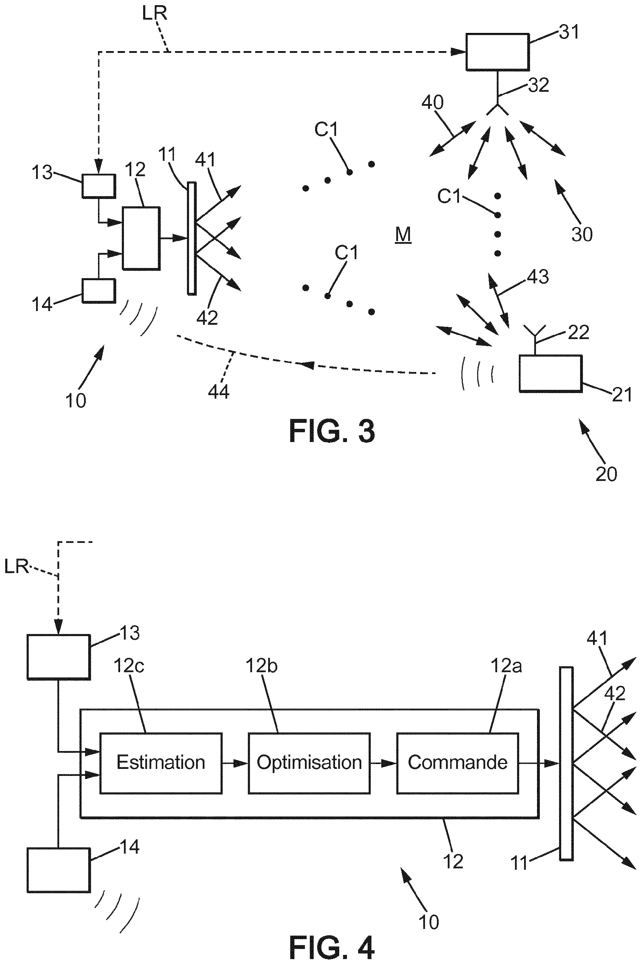

La **figure 3** montre une vue schématique montrant une utilisation générale d'un dispositif de mise en forme d'onde 10 selon un deuxième mode de réalisation de l'invention, qui améliore la réception d'une onde primaire par un récepteur 20.

Le système de ce deuxième mode de réalisation est similaire à celui du premier mode de réalisation, et ses variantes peuvent également s'appliquer avec les mêmes avantages respectifs.

Ce mode de réalisation diffère du précédent en ce que le dispositif de mise en forme 10 comprend en outre un dispositif de transmission 13 relié au contrôleur 12, et il est relié à l'émetteur 30 (qui émet l'onde primaire 40) par une liaison de réseau LR pour connaitre un instant temporel auquel l'émetteur 30 émet l'onde primaire 40.

En outre, comme représenté en **figures 3 et 4**, le module d'estimation 12c utilise la mesure de l'onde secondaire et cet instant temporel pour extraire la portion temporelle de la mesure de l'onde secondaire 44 qui est pertinente pour déterminer la valeur estimée concernant la réception par le récepteur 20.

Cette synchronisation temporelle du module d'estimation 12c avec l'émetteur permet d'améliorer la vitesse de convergence de l'optimisation et permet d'améliorer la performance de l'optimisation. Ainsi, la réception de l'onde primaire sur le récepteur est augmentée (niveau) et améliorée (qualité).

Selon une variante, l'émetteur 30 transmet également au dispositif de mise en forme d'onde 10, un code en même temps que l'instant temporel, et le module d'estimation 12c décode le signal de mesure de l'onde secondaire 44 et identifie ledit code dans cette onde secondaire 44 afin de confirmer que la mesure correspond bien à la réception du récepteur 20.

Selon une autre variante, l'émetteur 30 transmet au dispositif de mise en forme d'onde 10 une information additionnelle telle qu'une information temporelle ou une information fréquentielle ou une information numérique (comme un code) sur la transmission avec le récepteur 20, et le module d'estimation 12c effectue une comparaison avec le signal de mesure de l'onde secondaire 44 et identifie la communication dans cette onde secondaire 44.

La liaison de réseau LR est une liaison filaire (par exemple Ethernet) ou une liaison sans fil de type informatique ou de téléphone, selon l'un des protocoles déjà cité.

Comme déjà cité au début de cette description détaillée, le dispositif de mise en forme d'onde peut être implémenté dans de nombreuses applications.

**Selon une première application d'utilisation, de transmission sans fil d'énergie** (par exemple électromagnétique), le dispositif de mise en forme d'onde 10 selon l'invention permet d'optimiser le réglage de la surface adaptable 11 sans connexion avec le récepteur 20, ce récepteur 20 étant un module de récupération d'énergie de l'onde primaire transmise 43 reçue par ledit récepteur 20 ou même de toute onde de l'environnement ou milieu M reçue par le récepteur 20. Cette application est par exemple très utile pour alimenter par onde des capteurs sans fils, ou des objets autonomes connectés sans fil (internet des objets iOT, pour *« internet of things »)* .

Dans ce cas, le module d'estimation 12c détermine une valeur estimée qui correspond à une estimation de l'intensité ou énergie de l'onde primaire transmise 43 reçue par le récepteur.

Alors, le dispositif de mise en forme d'onde 10 améliore la récupération d'énergie de ce récepteur 20, module de récupération d'énergie sans fil.

Un module de récupération d'énergie est typiquement un dispositif non linéaire qui capture un signal d'une onde ambiante et le redresse pour former une tension continue. Ces dispositifs comprennent généralement des diodes qui sont des éléments non linéaires qui génèrent une onde secondaire qui est réémise par leur fonctionnement, onde secondaire qui est captée par le dispositif de réception 14 du dispositif de mise en forme d'onde 10.

De nombreux exemples de tels circuits existent.

Les inventeurs ont expérimenté cette application.

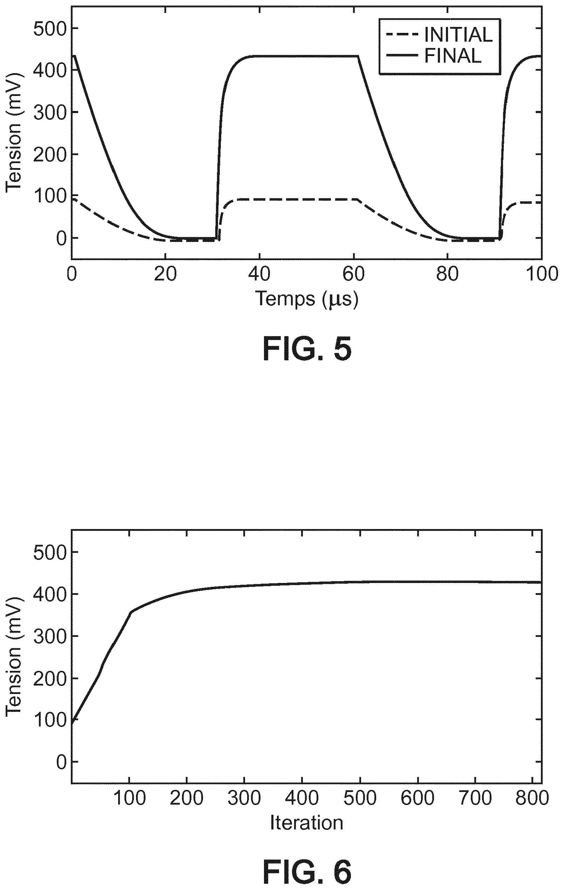

La **figure 5** représente des résultats obtenus avec un émetteur 30 qui émet une onde primaire 40 pendant des cycles de durée de 30µs. La courbe de cette figure montre l'évolution de la tension de sortie du module de récupération d'énergie. Le premier tracé en trait discontinu correspond à une configuration quelconque du dispositif se mis en forme d'onde 10. Le second tracé en trait continu correspond à une configuration après optimisation des paramètres de la surface adaptable 11 déterminée par le contrôleur 12 après environs 200 itérations, i.e. 200 cycles d'émission de l'onde primaire, ce qui correspond à un délai d'optimisation de 12 ms, seulement.

La **figure 6** représente l'évolution de la tension de sortie du module récupération d'énergie (sur son plateau pendant la réception de l'onde primaire avec un jeu de paramètres de la surface adaptable) en fonction du nombre d'itérations (i.e. cycles).

Le dispositif de mise en forme 10 d'onde détecte l'onde secondaire produite par la réception de l'onde primaire sur le récepteur, et sans connexion avec celui-ci, et optimise itération après itération la configuration de la surface adaptable 11 pour augmenter une valeur estimée qui est plus ou moins fonction de l'intensité (niveau) reçu par le récepteur 20. Cette boucle de rétraction indirecte et non volontaire du récepteur 20 est très largement suffisante dans le présent exemple pour augmenter d'un facteur 4 le niveau de tension de sortie du module de récupération d'énergie, et ceci avec un nombre très réduit d'itérations, donc très rapidement. On comprend que le dispositif de mise en forme d'onde 10 permet d'obtenir une meilleure alimentation, très rapidement, ce qui permet de réveiller plus rapidement un dispositif récepteur 20 autonome et/ou d'effectuer plus de traitements par ce récepteur autonome 20.

**Selon une deuxième application d'utilisation, de transmission de communication sans fil (en téléphonie sans fil ou en réseau sans fil),** le dispositif de mise en forme d'onde 10 selon l'invention permet d'optimiser le réglage de la surface adaptable 11 sans connexion avec le récepteur 20, ce récepteur 20 étant un dispositif de communication sans fil tel qu'un téléphone cellulaire ou un ordinateur avec une connexion Wifi, ou tout autre récepteur sans fil.

Dans ce cas, le module d'estimation 12c détermine une valeur estimée qui correspond à une estimation du niveau de réception ou de la qualité de réception de l'onde primaire transmise 43 reçue par ce récepteur 20, i.e. du niveau de réception ou de la qualité de réception de la communication sans fil réellement reçue.

L'émetteur 30 est par exemple un point d'accès ou station de réseau d'un réseau de communication sans fil, qui émet une onde primaire 40 dans le milieu M, ladite onde primaire 40 correspondant à une communication destinée à un récepteur 20 (dispositif récepteur de communication sans fil) dans un canal de communication C1.

Selon une première variante, le module d'estimation 12c espionne la communication par une mesure de l'onde primaire 40 émise par émetteur (point d'accès) 30, et effectue un traitement de décodage de ce signal de mesure de l'onde primaire pour en extraire des données de ladite communication, puis sélectionne des données correspondant à des informations utiles pour déterminer la valeur estimée du processus d'optimisation du dispositif de mise en forme d'onde 10.

En effet, les dispositifs récepteurs de communication sans fil estiment aussi eux même le niveau et la qualité de la communication qu'ils reçoivent et renvoient ces informations à l'émetteur (point d'accès) 30. L'émetteur (point d'accès) 30 fait réciproquement le même processus d'échange de données sur la communication sans fil. Le dispositif de mise en forme d'onde 10 espionne donc cette communication sans que cette information soit demandée ou sollicité au récepteur 20.

La mesure de l'onde primaire effectuée par le dispositif de mise en forme d'onde là pour faire l'espionnage est :
- soit réalisée par un dispositif de transmission 13 de type sans fil, indépendamment du dispositif de réception (14) qui mesure l'onde secondaire résultante de la communication avec le récepteur 20 ;
- soit réalisée par le dispositif de réception 14, lui-même, qui sert alors à mesurer l'onde primaire pour effectuer cet espionnage de la communication et qui sert à mesurer l'onde secondaire.

Le module d'estimation 12c utilise alors toutes les informations qu'il peut extraire de la communication et l'image de la réception de cette communication qui est dans la mesure de l'onde secondaire, pour déterminer la valeur estimée du processus d'optimisation du dispositif de mise en forme 10 décrit ici.

Selon une deuxième variante, le dispositif de mise en forme d'onde 10 est avantageusement relié à l'émetteur (point d'accès) 30 comprend un dispositif de transmission 13 qui relie le contrôleur 12 à l'émetteur (point d'accès) 30 de l'onde primaire par une liaison de réseau LR tel que présenté ci-dessus dans le deuxième mode de réalisation de l'invention (figures 3 et 4). Cela lui permet de récupérer de l'émetteur 30 :
- un code d'identification communication pour identifier la communication entre l'émetteur 30 et le récepteur 20 parmi une pluralité de récepteurs ; et/ou
- une information d'instant temporel auquel l'émetteur 30 émet l'onde primaire 40 à destination du récepteur 20 particulier.

Dans ce cas, l'instant temporel est l'instant auquel l'émetteur (point d'accès) 30 établit une communication avec le récepteur (dispositif de communication sans fil) 20 dans ce canal de communication C1.

Ainsi, l'émetteur (point d'accès) 30 transmet au dispositif de mise en forme d'onde l'instant temporel auquel il établit une communication avec le récepteur (dispositif de communication sans fil) 20 pour que le dispositif de mise en forme d'onde 10 mesure une onde secondaire et détermine une valeur estimée de la réception de ladite communication (niveau, qualité).

Optionnellement, l'émetteur (point d'accès) 30 transmet également au dispositif de mise en forme d'onde 10 une information additionnelle pour reconnaitre et/identifier ladite communication, comme décrit ci-dessus (fréquences, canal, code d'identification de communication).

Les deux variantes précédentes peuvent être combinées : le dispositif de mise en forme d'onde 10 espionne la communication et reçoit des informations par l'émetteur 30.

**Selon une troisième application d'utilisation,** le dispositif de mise en forme d'onde 10 selon l'invention permet est utilisé simultanément et/ou quasi simultanément pour les deux applications précédemment présentées :
- l'amélioration de la transmission d'énergie sans fil entre un émetteur d'énergie sans fil par onde et le récepteur 20, et
- l'amélioration d'une communication sans fil par onde entre un émetteur de communication sans fil et le récepteur 20.

Le récepteur 20 comprend ainsi :
- une ou plusieurs antennes 22,
- un module de récupération d'énergie de l'onde primaire transmise 43 reçue par le récepteur, et
- un module de communication de l'onde primaire transmise 43 reçue/émise par le récepteur.

Ainsi, le dispositif de mise en forme d'onde 10 optimise le réglage de la surface adaptable 11 sans connexion avec le récepteur 20, seulement avec les ondes secondaires générées de manière autonome à la réception de l'onde primaire transmise 43 reçue par le récepteur 20.

En variante, le récepteur 20 reçoit une première onde primaire pour son module de récupération d'énergie, et une deuxième onde primaire pour son module de communication. La première onde primaire et deuxième onde primaire sont éventuellement différentes en nature, et fréquence, et elles sont éventuellement générées dans le milieu par des émetteurs spécialisés différents.

Ainsi, le dispositif de mise en forme d'onde 10 optimise le réglage de la surface adaptable 11 sans connexion avec le récepteur 20, seulement avec les première et deuxième ondes secondaires. La surface adaptable 11 comprend par exemple des éléments adaptables adaptés à chacune desdites première et deuxième ondes primaires.

En variante, il y a deux dispositifs de mise en forme d'onde 10, 10', un premier pour l'optimisation de la réception de la première onde primaire, et un second pour l'optimisation de la seconde onde primaire, ces deux dispositifs de mise en forme d'onde 10, 10' pouvant être interconnectés par tout moyen pour améliorer et synchroniser leurs optimisations respectives.

Ces dispositifs de mise en forme d'onde 10 sont donc très utiles pour alimenter par onde et pour améliorer les communications sans fil de capteurs sans fils ou d'objets autonomes connectés sans fil (internet des objets iOT, pour « *internet of things* »), ces objets ayant un besoin d'autonomie et de communication des données mesurées.

**Selon une quatrième application d'utilisation, de détection d'un badge,** par exemple un badge d'identification, par exemple de type RFID ou de toute autre technologie de badge d'identification, le dispositif de mise en forme d'onde 10 selon l'invention permet d'optimiser le réglage de la surface adaptable 11 sans connexion avec le récepteur 20, ce récepteur 20 étant ledit badge.

Dans ce cas, le module d'estimation 12c détermine une valeur estimée qui correspond à une estimation de l'intensité ou du niveau de réception de l'onde primaire transmise 43 reçue par ce récepteur 20.

Le dispositif de mise en forme d'onde 10 améliore la réception de cette onde primaire transmise 43 par le récepteur 20 (le badge).

Le récepteur 20 (badge) génère alors une onde secondaire en réponse à la réception de l'onde primaire transmise 43. Dans un tel cas, cette onde secondaire comprend un code numérique d'identification du badge. L'onde secondaire est alors captée par le dispositif de réception 14 du dispositif de mise en forme d'onde 10.

L'émetteur 30 fait partie d'un système qui cherche à identifier des badges. Il émet l'onde primaire 40 dans le milieu M pour rechercher et faire réagir un ou plusieurs récepteurs 20 (badges) dans le milieu M afin de les identifier.

Selon une première variante, le dispositif de mise en forme d'onde 10 fonctionne de manière indépendante de l'émetteur 30 et/ou du système d'identification de badges.

Dans ce cas, après la réception d'une onde secondaire, le dispositif de mise en forme d'onde 10 peut faire varier l'impédance (électromagnétique) de la surface adaptable 11. Par exemple, cette adaptation/optimisation (telle qu'explicité précédemment) peut être effectuée dès la seconde réception ou après, et pour chaque nouvelle réception ou selon une périodicité prédéfinie.

Le système d'identification de badge reçoit également de son côté l'onde secondaire par une antenne (par exemple l'antenne de réseau 32 de l'émetteur 30) et effectue la lecture ou le décodage du code numérique d'identification inclus dans le signal de l'onde secondaire.

Selon une seconde variante, le dispositif de mise en forme 10 est relié ou fait partie du système de d'identification des badges. Il n'est donc pas indépendant de celui-ci.

Dans ce cas, le système d'identification de badge peut éventuellement attendre que l'optimisation du dispositif de mise en forme d'onde 10 soit finalisée avant d'effectuer la lecture ou le décodage du code numérique d'identification inclus dans le signal de l'onde secondaire.

Eventuellement, l'antenne de réseau 32 et le dispositif de réception 14 ne sont qu'un seul et même dispositif d'émission et/ou réception d'onde.

Le dispositif de mise en forme d'onde 10 permet donc d'améliorer la réception de l'onde secondaire d'un système d'identification de badge. Il permet également d'améliorer la lecture ou le décodage du code numérique d'identification d'un récepteur 20 (badge). Cette lecture ou décodage peut être effectuée plus rapidement, et le système d'identification de badge est capable de lire plus rapidement une pluralité de badges dans le milieu M.

Enfin, le dispositif de mise en forme d'onde 10 ou seulement la surface adaptable 11 peuvent être directement intégrés dans un élément de construction de bâtiment : un parpaing, une brique, un isolant, une plaque isolante, une plaque de plâtre, ou autre.

Le dispositif de mise en forme d'onde 10 ou seulement la surface adaptable 11 peuvent également être directement intégrés dans des éléments d'habillage de bâtiment : un sol en parquet, un sol en moquette, un sol en carrelage, un panneau d'habillage, une cloison rapportée, un plafond, une plaque de faux plafond, ou autre.

Le dispositif de mise en forme d'onde 10 ou seulement la surface adaptable 11 peuvent également être directement intégrés dans des éléments de mobilier : un bureau, une armoire, un meuble à étagère, une étagère, un miroir, un tableau décoratif, un luminaire.

Cet élément comprend au moins la surface adaptable 11 du dispositif de réflexion ou tout le dispositif de mise en forme d'onde 10. Il peut être alimenté depuis l'extérieur, ou comprendre une batterie, ou être alimenté à distance par induction de manière permanente ou non.

Enfin, selon les divers modes de réalisation, **le récepteur d'onde 20** comprend :
- une antenne 22 adaptée pour recevoir une onde primaire d'un émetteur 30, et
- une unité de traitement 21 reliée à ladite antenne 22 pour traiter les signaux provenant de l'antenne 22.

Le récepteur 20 est alors avantageusement adapté pour être utilisé avec le dispositif de mise en forme d'onde 10.

Selon une première variante, l'antenne 22 est reliée à un élément de signature adapté pour faire émettre audit récepteur une onde secondaire qui est fonction de l'onde primaire reçue par ladite antenne.

Notamment, le dispositif de mise en forme d'onde 10 connait les caractéristiques particulières (et uniques) de cet élément de signature pour que son processus de reconnaissance identifie le récepteur 20 correspondant à l'onde secondaire qu'il reçoit.

Par exemple, l'élément de signature est un élément passif, qui ne consomme pas ou peu d'énergie.

Par exemple, l'élément de signature est un élément non linéaire qui déforme le signal de l'onde primaire avec une signature prédéterminée pour générer le signal de l'onde secondaire.

Par exemple, l'élément de signature est un circuit électrique non linéaire qui déforme le signal de l'onde primaire avec une signature prédéterminée pour générer le signal de l'onde secondaire.

Comme déjà explicité dans la précédente description du module d'estimation 12c, et de manière réciproque et similaire, l'onde primaire a une fréquence principale, et la signature prédéterminée est au moins une fréquence de signature différente de ladite fréquence principale.

La fréquence de signature est éventuellement une harmonique entière supérieure ou inférieure de la fréquence principale.

Selon une seconde variante, un élément de signature est fixé sur le récepteur 20, sans avoir aucun lien autre que cette liaison mécanique. L'élément de signature émet une onde secondaire en relation avec l'onde primaire qu'il reçoit en même temps que l'antenne 22 du récepteur.

L'onde secondaire de l'élément de signature est reçue par le dispositif de mise en forme 10 qui en connait les caractéristiques particulières.

Avantageusement, l'élément de signature a une fréquence de fonctionnement commune avec l'antenne 22 du récepteur 20, c'est-à-dire avec l'onde primaire 40.

Dans les deux variantes précédentes, l'élément de signature est par exemple un badge d'identification, par exemple de type RFID ou de toute autre technologie de badge d'identification.

Ainsi, l'élément de signature apporte au récepteur 20 les caractéristiques particulières pour que le dispositif de mise en forme d'onde 10 s'adapte à cet élément de signature, ce qui a pour effet d'adapter ou optimiser également la réception de l'onde primaire pour l'antenne 22 du récepteur 20.

Par exemple, l'élément de signature peut être un élément RFID fixé à un récepteur 20 avec une antenne 22 de type Bluetooth, l'élément RFID et l'antenne 22 ayant au moins une fréquence en commun. Le dispositif de mise en forme d'onde 10 optimise la réception de l'élément de signature (RFID), ce qui améliore ainsi également la réception de l'onde primaire Bluetooth par l'antenne 22 du récepteur.

## Revendications

1. **Système** comprenant un émetteur (30) adapté pour émettre une onde primaire, un récepteur (20) adapté pour recevoir l'onde primaire et, et un dispositif de mise en forme d'onde (10) adapté pour améliorer au niveau du récepteur la réception de l'onde primaire, dans lequel :
- le récepteur (20) comprend :
- une antenne (22) adaptée pour recevoir l'onde primaire provenant de l'émetteur (30), et
- une unité de traitement (21) reliée à ladite antenne (22) pour traiter les signaux provenant de l'antenne (22), et
- un élément de signature adapté pour émettre une onde secondaire qui est fonction de l'onde primaire reçue par l'antenne,
- l'élément de signature étant un circuit électrique non linéaire adapté pour déformer le signal de l'onde primaire avec une signature prédéterminée pour générer le signal de l'onde secondaire,
- le dispositif de mise en forme d'onde (10) comprend :
- une surface (11) qui interagit avec l'onde primaire, ladite surface comprenant une pluralité d'éléments réglables pour modifier une impédance de ladite surface et pour modifier la manière dont l'onde primaire est réfléchie et transmise par ladite surface, et
- un contrôleur (12) relié à la surface, ledit contrôleur comprenant un module d'optimisation (12b) qui maximise ou minimise une valeur pour déterminer des paramètres, et ledit contrôleur est adapté pour contrôler les éléments réglables à partir desdits paramètres,
- un dispositif de réception d'onde (14) qui est connecté au contrôleur et qui est adapté pour mesurer une onde secondaire générée par la réception de l'onde primaire par le récepteur, sans que le récepteur ne transmette au dispositif de mise en forme d'onde une information concernant sa réception de l'onde primaire, et
- le contrôleur (12) comprenant un module d'estimation (12c) adapté pour déterminer une valeur estimée de la réception de l'onde primaire par le récepteur grâce à la mesure de l'onde secondaire, et le module d'optimisation (12b) du contrôleur est adapté pour utiliser ladite valeur estimée pour déterminer les paramètres de contrôle des éléments réglables.

2. Le système selon la revendication 1, comprenant en outre un dispositif de transmission (13) relié au contrôleur et relié au à l'émetteur de l'onde primaire par une liaison de réseau LR pour connaître un instant
temporel auquel l'émetteur émet l'onde primaire, et dans lequel le module d'estimation (12c) est adapté pour utiliser ledit instant
temporel pour déterminer la valeur estimée concernant ledit récepteur.

3. Le système selon l'une des revendications 1 à 2, dans lequel le module d'estimation (12c) est adapté pour effectuer une reconnaissance du récepteur par la comparaison d'un traitement de la mesure de l'onde secondaire à une signature prédéterminée correspondant audit récepteur, puis en déduit la valeur estimée.

4. Le système selon la revendication 3, dans lequel la comparaison est un calcul de corrélation ou d'inter-corrélation entre le traitement de la mesure de l'onde secondaire et signature prédéterminée.

5. Le système selon la revendication 3, dans lequel le traitement comprend une extraction d'un signal temporel, par exemple par filtrage.

6. Le système selon la revendication 3, dans lequel l'onde primaire a une fréquence principale, et dans lequel le traitement comprend une extraction d'au moins une fréquence de signature différente de ladite fréquence principale.

7. Le système selon la revendication 6, dans lequel la fréquence de signature est une harmonique entière supérieure ou inférieure de la fréquence principale.

8. Le système selon la revendication 3, dans lequel le traitement comprend une détection hétérodyne qui est adaptée pour abaisser les fréquences de la mesure de l'onde secondaire.

9. Le système selon la revendication 3, dans lequel le traitement comprend un décodage d'un code numérique inclut dans la mesure de l'onde secondaire.

10. Le système selon l'une des revendications 1 à 9, dans lequel le dispositif de réception d'onde (14) comprend une antenne multiple pour spatialement sélectionner une région incluant récepteur.

11. Le système selon l'une des revendications 1 à 10, dans lequel le dispositif de réception d'onde (14) est adapté pour effectuer une focalisation sur le récepteur par formation de voie.

12. Le système selon l'une des revendications 1 à 11, dans lequel :
- le récepteur est un module de récupération d'énergie de l'onde primaire, et
- la valeur estimée correspond à une estimation de l'intensité de l'onde primaire reçue par le récepteur.

13. Le système selon l'une des revendications 1 à 11, dans lequel :
- le récepteur est un dispositif de communication sans fil (20),
- l'émetteur est un point d'accès (30) d'un réseau de communication sans fil, adapté pour émettre une onde primaire correspondant à une communication avec le dispositif de communication sans fil.

14. Le système selon la revendication 13, dans lequel le module d'estimation (12c) est adapté pour espionner la communication par une mesure de l'onde primaire et en extrait des données pour déterminer la valeur estimée.

15. Le système selon la revendication 14, dans lequel la mesure de l'onde primaire pour espionner la communication est effectuée par le dispositif de réception d'onde (14) qui est adapté pour mesurer l'onde secondaire.

16. Le système selon la revendication 13 et la revendication 2, dans lequel l'instant temporel est l'instant auquel le point d'accès établit ladite communication avec le dispositif de communication sans fil.

17. Le système selon la revendication 13 et la revendication 2, dans lequel le module d'estimation (12c) est adapté pour recevoir du point d'accès (30) et par la liaison de réseau LR connectée au dispositif de transmission (13), la communication entre ledit point d'accès et le récepteur, et en extrait des données pour déterminer la valeur estimée.

18. Le système selon la revendication 1, dans lequel l'élément de signature est relié à l'antenne (22) pour lui faire émettre l'onde secondaire.

19. Le système selon la revendication 1 ou la revendication 18, dans lequel l'élément de signature est un élément passif.

20. Le système selon la revendication 1, dans lequel l'onde primaire a une fréquence principale, et dans lequel la signature prédéterminée est au moins une fréquence de signature différente de ladite fréquence principale.

21. Le système de la revendication 20, dans lequel la fréquence de signature est une harmonique entière supérieure ou inférieure de la fréquence principale.

## Patentansprüche

1. System, umfassend einen Sender (30), der dazu ausgebildet ist, eine Primärwelle zu senden, einen Empfänger (20), der dazu ausgebildet ist, die Primärwelle zu empfangen, und eine Wellenformungsvorrichtung (10), die dazu ausgebildet ist, am Empfänger den Empfang der Primärwelle zu verbessern, wobei:
- der Empfänger (20) umfasst:
- eine Antenne (22), die dazu ausgebildet ist, die vom Sender (30) stammende Primärwelle zu empfangen, und
- eine Verarbeitungseinheit (21), die mit der Antenne (22) verbunden ist, um die von der Antenne (22) stammenden Signale zu verarbeiten, und
- ein Signaturelement, das dazu ausgebildet ist, eine Sekundärwelle zu senden, die eine Funktion der von der Antenne empfangenen Primärwelle ist,
- wobei das Signaturelement ein nichtlinearer elektrischer Schaltkreis ist, der dazu ausgebildet ist, das Signal der Primärwelle mit einer vorbestimmten Signatur zu verformen, um das Signal der Sekundärwelle zu erzeugen,
- die Wellenformungsvorrichtung (10) umfasst:
- eine Oberfläche (11), die mit der Primärwelle in Wechselwirkung steht, wobei die Oberfläche eine Vielzahl von Elementen umfasst, die einstellbar sind, um eine Impedanz der Oberfläche zu verändern und um die Art und Weise zu verändern, in der die Primärwelle von der Oberfläche reflektiert und übertragen wird, und
- eine Steuerung (12), die mit der Oberfläche verbunden ist, wobei die Steuerung ein Optimierungsmodul (12b) umfasst, das einen Wert maximiert oder minimiert, um Parameter zu bestimmen, und wobei die Steuerung dazu ausgebildet ist, die anhand der Parameter einstellbaren Elemente zu steuern,
- eine Wellenempfangsvorrichtung (14), die mit der Steuerung verbunden ist und dazu ausgebildet ist, eine Sekundärwelle zu messen, die durch den Empfang der Primärwelle durch den Empfänger erzeugt wird, ohne dass der Empfänger Informationen über seinen Empfang der primären Welle an die Wellenformungsvorrichtung überträgt, und
- wobei die Steuerung (12) ein Schätzmodul (12c) umfasst, das dazu ausgebildet ist, einen Schätzwert für den Empfang der Primärwelle durch den Empfänger mithilfe der Messung der Sekundärwelle zu bestimmen, und wobei das Optimierungsmodul (12b) der Steuerung dazu ausgebildet ist, den Schätzwert heranzuziehen, um die Steuerparameter der einstellbaren Elemente zu bestimmen.

2. System nach Anspruch 1, welches ferner eine Übertragungsvorrichtung (13) umfasst, die mit der Steuerung und über eine LR-Netzwerkverbindung mit dem Sender der Primärwelle verbunden ist, um einen Zeitpunkt zu erkennen, an dem der Sender (12c) die Primärwelle sendet und wobei das Schätzmodul (12c) dazu ausgebildet ist, den Schätzwert bezüglich des Empfängers zu bestimmen.

3. System nach einem der Ansprüche 1 bis 2, wobei das Schätzmodul (12c) dazu ausgebildet ist, eine Erkennung des Empfängers durchzuführen, indem es eine Verarbeitung der Messung der Sekundärwelle mit einer vorbestimmten Signatur vergleicht, die dem Empfänger entspricht, und dann den Schätzwert daraus ableitet.

4. System nach Anspruch 3, wobei der Vergleich eine Korrelations- oder Interkorrelationsberechnung zwischen der Verarbeitung der Messung der Sekundärwelle und der vorbestimmten Signatur ist.

5. System nach Anspruch 3, wobei die Verarbeitung eine Extraktion eines Zeitsignals, beispielsweise durch Filtern, umfasst.

6. System nach Anspruch 3, wobei die Primärwelle eine Hauptfrequenz aufweist und wobei die Verarbeitung eine Extraktion wenigstens einer Signaturfrequenz umfasst, die sich von der Hauptfrequenz unterscheidet.

7. System nach Anspruch 6, wobei die Signaturfrequenz eine ganze Harmonische kleiner gleich der Hauptfrequenz ist.

8. System nach Anspruch 3, wobei die Verarbeitung eine Heterodynerkennung umfasst, die dazu ausgebildet ist, die Frequenzen der Messung der Sekundärwelle zu senken.

9. System nach Anspruch 3, wobei die Verarbeitung eine Decodierung eines digitalen Codes umfasst, der in der Messung der Sekundärwelle enthalten ist.

10. System nach einem der Ansprüche 1 bis 9, wobei die Wellenempfangsvorrichtung (14) eine Mehrfachantenne zur räumlichen Auswahl einer Region umfasst, die den Empfänger umfasst.

11. System nach einem der Ansprüche 1 bis 10, wobei die Wellenempfangsvorrichtung (14) dazu ausgebildet ist, eine Fokussierung auf den Empfänger durch Kanalbildung zu bewirken.

12. System nach einem der Ansprüche 1 bis 11, wobei:
- der Empfänger ein Modul zur Wiedergewinnung von Energie aus der Primärwelle ist, und
- der geschätzte Wert einer Schätzung der Intensität der vom Empfänger empfangenen Primärwelle entspricht.

13. System nach einem der Ansprüche 1 bis 11, wobei:
- der Empfänger ein drahtloses Kommunikationsgerät (20) ist,
- der Sender ein Zugangspunkt (30) eines drahtlosen Kommunikationsnetzes ist, der dazu ausgebildet ist, eine Primärwelle zu senden, die einer Kommunikation mit der drahtlosen Kommunikationsvorrichtung entspricht.

14. System nach Anspruch 13, wobei das Schätzmodul (12c) dazu ausgebildet ist, die Kommunikation durch eine Messung der Primärwelle auszuspionieren und daraus Daten zur Bestimmung des Schätzwerts zu extrahieren.

15. System nach Anspruch 14, wobei die Messung der Primärwelle zum Ausspionieren der Kommunikation von der Wellenempfangsvorrichtung (14) durchgeführt wird, die dazu ausgebildet ist, die Sekundärwelle zu messen.

16. System nach Anspruch 13 und Anspruch 2, wobei der Zeitpunkt derjenige Zeitpunkt ist, zu dem der Access Point die Kommunikation mit der drahtlosen Kommunikationsvorrichtung aufnimmt.

17. System nach Anspruch 13 und Anspruch 2, wobei das Schätzmodul (12c) dazu ausgebildet ist, von dem Access Point (30) und über die mit der Übertragungsvorrichtung (13) verbundene LR-Netzwerkverbindung die Kommunikation zwischen dem Access Point und dem Empfänger zu empfangen und daraus Daten zur Bestimmung des geschätzten Wertes zu extrahieren.

18. System nach Anspruch 1, wobei das Signaturelement mit der Antenne (22) verbunden ist, um diese dazu zu veranlassen, die Sekundärwelle zu senden.

19. System nach Anspruch 1 oder Anspruch 18, wobei das Signaturelement ein passives Element ist.

20. System nach Anspruch 1, wobei die Primärwelle eine Hauptfrequenz aufweist, und wobei die vorbestimmte Signatur wenigstens eine Signaturfrequenz ist, die sich von der Hauptfrequenz unterscheidet.

21. System nach Anspruch 20, wobei die Signaturfrequenz eine größere oder kleinere ganze Harmonische der Hauptfrequenz ist.

## Claims

1. **System** comprising an emitter (30) adapted to emit a primary wave, a receiver (20) adapted to receive the primary wave, and a wave shaping device (10) adapted to improve, at the receiver, the reception of the primary wave, wherein:
- the receiver (20) comprises:
- an antenna (22) adapted to receive the primary wave from the emitter (30), and
- a processing unit (21) connected to said antenna (22) in order to process the signals coming from the antenna (22), and
- a signature element adapted to emit a secondary wave which is a function of the primary wave received by the antenna,
- the signature element being a non-linear electrical circuit adapted to deform the signal of the primary wave with a predetermined signature in order to generate the secondary wave signal,
- the wave shaping device (10) comprises:
- a surface (11) which interacts with the primary wave, said surface comprising a plurality of adjustable elements for modifying an impedance of said surface and for modifying the manner in which the primary wave is reflected and transmitted by said surface, and
- a controller (12) connected to the surface, said controller comprising an optimization module (12b) which maximizes or minimizes a value for determining parameters, and said controller adapted to control the adjustable elements based on said parameters,
- a wave receiving device (14) which is connected to the controller and which is adapted to measure a secondary wave generated by the reception of the primary wave by the receiver, without the receiver transmitting information to the wave shaping device concerning its reception of the primary wave, and
- the controller (12) comprising an estimation module (12c) adapted to determine an estimated value for the reception of the primary wave by the receiver, by means of the measurement of the secondary wave, and the optimization module (12b) of the controller is adapted to use said estimated value to determine the control parameters of the adjustable elements.

2. System according to claim 1, further comprising a transmission device (13) connected to the controller and connected to the transmitter of the primary wave by a network link LR in order to know a time instant at which the transmitter emits the primary wave, and wherein the estimation module (12c) is adapted to use said time instant to determine the estimated value for said receiver.

3. System according to one of claims 1 to 2, wherein the estimation module (12c) is adapted to perform a recognition of the receiver by comparing a processing of the measurement of the secondary wave with a predetermined signature corresponding to said receiver, and then deduces the estimated value.

4. System according to claim 3, wherein the comparison is a calculation of the correlation or inter-correlation between the processing of the measurement of the secondary wave and the predetermined signature.

5. System according to claim 3, wherein the processing comprises an extraction of a time signal, for example by filtering.

6. System according to claim 3, wherein the primary wave has a main frequency, and wherein the processing comprises an extraction of at least one signature frequency different from said main frequency.

7. System according to claim 6, wherein the signature frequency is an integer harmonic higher or lower than the main frequency.

8. System according to claim 3, wherein the processing comprises a heterodyne detection which is adapted to lower the frequencies of the measurement of the secondary wave.

9. System according to claim 3, wherein the processing comprises a decoding of a numeric code included in the measurement of the secondary wave.

10. System according to one of claims 1 to 9, wherein the wave receiving device (14) comprises a multi-antenna for spatially selecting a region including the receiver.

11. System according to one of claims 1 to 10, wherein the wave receiving device (14) is adapted to perform a focussing on the receiver by beamforming.

12. System according to one of claims 1 to 11, wherein:
- the receiver is a module for recovering energy from the primary wave, and
- the estimated value corresponds to an estimate of the intensity of the primary wave received by the receiver.

13. System according to one of claims 1 to 11, wherein:
- the receiver is a wireless communication device (20),
- the transmitter is an access point (30) of a wireless communication network, which is adapted to emit a primary wave corresponding to a communication with the wireless communication device.

14. System according to claim 13, wherein the estimation module (12c) is adapted to spy the communication by measuring the primary wave and extracts data to determine the estimated value.

15. System according to claim 14, wherein the measurement of the primary wave in order to spy on the communication is performed by the wave receiving device (14) which is adapted to measure the secondary wave.

16. System according to claim 13 and claim 2, wherein the time instant is the time at which the access point establishes said communication with the wireless communication device.

17. System according to claim 13 and claim 2, wherein the estimation module (12c) is adapted to receive, from the access point (30) and via the network link LR connected to the transmission device (13), the communication between said access point and the receiver, and extracts data therefrom to determine the estimated value.

18. System according to claim 1, wherein the signature element is connected to the antenna (22) in order to cause it to emit the secondary wave.

19. System according to claim 1 or claim 18, wherein the signature element is a passive element.

20. Receiver according to claim 1, wherein the primary wave has a main frequency, and wherein the predetermined signature is at least one signature frequency different from said main frequency.

21. Receiver according to claim 20, wherein the signature frequency is an integer harmonic higher or lower than the main frequency.
